# EUROPEAN PATENT APPLICATION

(11) **EP 3 457 449 A1**
(43) Date of publication of application: **20.03.2019**
(21) Application number: 17795920.2
(22) Date of filing: 20.04.2017
(51) Int. Cl.: H01L 51/50, C08G 61/12, G09F 9/30, H01L 27/32, H05B 33/10

(54) **CHARGE TRANSPORT MATERIAL, ORGANIC ELECTRONIC ELEMENT AND ORGANIC ELECTROLUMINESCENT ELEMENT**

(30) Priority: 10.05.2016 JP 2016094599
(71) Applicant: Hitachi Chemical Company, Ltd., Chiyoda-ku Tokyo 100-6606 (JP)
(72) Inventor: YOSHINARI, Yuki, Tokyo 100-6606 (JP); FUNYUU, Shigeaki, Tokyo 100-6606 (JP); SAKUMA, Hirotaka, Tokyo 100-6606 (JP); UEDA, Shunsuke, Tokyo 100-6606 (JP); ISHITSUKA, Kenichi, Tokyo 100-6606 (JP)
(74) Representative: Hoffmann Eitle
(86) International application number: PCT/JP2017/015893
(87) International publication number: WO 2017/195559

(57) **Abstract**

One embodiment relates to a charge transport material containing a charge transport polymer A having at least one type of group selected from the group consisting of fluoroalkyl groups and fluoroaryl groups, and a charge transport polymer B having no fluoroalkyl groups and no fluoroaryl groups.

## Description

### Technical Field

Embodiments of the present invention relate to a charge transport material, an ink composition, an organic layer, an organic electronic element, an organic electroluminescent element (organic EL element), a display element, an illumination device and a display device, and also relate to methods for producing an organic layer, an organic electronic element and a charge transport material.

### Background Art

Organic electronic elements are elements which use an organic substance to perform an electrical operation, and because they are expected to be capable of providing advantages such as low energy consumption, low prices and superior flexibility, they are attracting considerable attention as a potential alternative technology to conventional inorganic semiconductors containing mainly silicon.

Examples of organic electronic elements include organic EL elements, organic photoelectric conversion elements, and organic transistors and the like.

Among organic electronic elements, organic EL elements are attracting attention for potential use in large-surface area solid state lighting applications to replace incandescent lamps or gas-filled lamps or the like. Further, organic EL elements are also attracting attention as the leading self-luminous display for replacing liquid crystal displays (LCD) in the field of flat panel displays (FPD), and commercial products are becoming increasingly available.

Examples of the methods used for stacking organic materials in organic EL elements include vacuum deposition methods and wet film formation methods (for example, see Patent Literature 1). In a vacuum deposition method, a plurality of organic layers can be stacked easily by sequentially altering the compound used for deposition. However, because a vacuum process is required, a problem arises in that increasing the surface area is difficult.

Accordingly, in recent years, methods that do not require a vacuum process, and enable an organic layer to be formed by applying a charge transport polymer using a wet film formation method such as a spin coating method or an inkjet method are being actively investigated.

### Citation List

### Patent Literature

PLT 1: JP 2006-279007 A

### Summary of Invention

### Technical Problem

Organic EL elements produced using charge transport polymers have the advantages that cost reductions and surface area increases can be achieved with relative ease. However, improvements are still required in the properties of the resulting organic EL elements.

Accordingly, embodiments of the present invention aim to provide a charge transport material, an ink composition and an organic layer that are suitable for improving the properties of organic electronic elements. Further, other embodiments of the present invention aim to provide an organic electronic element, an organic EL element, a display element, an illumination device and a display device that have excellent element properties. Moreover, other embodiments of the present invention aim to provide methods for efficiently producing the aforementioned organic layer, organic electronic element and organic EL element.

### Solution to Problem

As a result of intensive investigation, the inventors of the present invention discovered that by using a charge transport polymer having a fluoroalkyl group and/or a fluoroaryl group, the properties of organic EL elements could be improved, and they were therefore able to complete the present invention.

The present invention includes a large variety of embodiments. Examples of the embodiments are described below. However, the present invention is not limited to the following embodiments.

One embodiment of the present invention relates to a charge transport material containing a charge transport polymer A having at least one type of group selected from the group consisting of fluoroalkyl groups and fluoroaryl groups, and a charge transport polymer B having no fluoroalkyl groups and no fluoroaryl groups.

In one embodiment, the charge transport material can be used in the formation of at least one type of layer selected from the group consisting of hole injection layers, hole transport layers, and electron blocking layers.

In one embodiment, at least one polymer selected from the group consisting of the charge transport polymer A and the charge transport polymer B may have a branched structure.

In one embodiment, the number average molecular weights of the charge transport polymer A and the charge transport polymer B are preferably both 1,000 or greater.

In one embodiment, the charge transport polymer A and the charge transport polymer B both include at least one type of structural unit selected from the group consisting of structural units containing an aromatic amine structure and structural units containing a carbazole structure.

Another embodiment of the present invention relates to an ink composition containing the above charge transport material and a solvent.

Another embodiment of the present invention relates to an organic layer containing the above charge transport material, wherein the charge transport polymer A is localized at one surface of the organic layer.

Another embodiment of the present invention relates to an organic electronic element having the above organic layer.

Another embodiment of the present invention relates to an organic electroluminescent element having the above organic layer.

Other embodiments of the present invention relate to a display element or an illumination device containing the above organic electroluminescent element, or to a display device containing the above illumination device and a liquid crystal element as a display unit.

Other embodiments of the present invention relate to a method for producing an organic layer that includes a step of coating the above ink composition, a method for producing an organic electronic element that includes a step of coating the above ink composition, or a method for producing an organic electroluminescent element that includes a step of coating the above ink composition.

The disclosure of the present application is related to the subject matter disclosed in prior Japanese Application 2016-94599 filed on May 10, 2016, the entire contents of which are incorporated by reference herein.

### Advantageous Effects of Invention

Embodiments of the present invention are able to provide a charge transport material, an ink composition and an organic layer that are suitable for improving the properties of organic electronic elements. Further, other embodiments of the present invention are able to provide an organic electronic element, an organic EL element, a display element, an illumination device and a display device that have excellent element properties. Moreover, other embodiments of the present invention are able to provide methods for efficiently producing the above organic layer, organic electronic element and organic EL element.

### Brief Description of Drawings

FIG. 1 is a schematic cross-sectional view illustrating one embodiment of an organic EL element of the present invention.
FIG. 2 is a schematic cross-sectional view illustrating one embodiment of an organic EL element of the present invention.

### Description of Embodiments

Embodiments of the present invention are described below. However, the description below merely provides examples of the embodiments of the present invention, and the present invention is not limited to these embodiments.

### <Charge Transport Material>

The charge transport material that represents one embodiment of the present invention contains a charge transport polymer A having at least one type of group selected from the group consisting of fluoroalkyl groups and fluoroaryl groups, and a charge transport polymer B having no fluoroalkyl groups and no fluoroaryl groups. The charge transport material may contain a single type, or two or more types, of each of the charge transport polymer A and the charge transport polymer B.

By using the charge transport material of this embodiment, the properties of organic electronic elements can be improved. The reason for that improvement is thought to be as follows. Specifically, by forming an organic layer using the charge transport material of this embodiment, the charge transport polymer A can be localized at one surface of the organic layer. When this occurs, polymers other than the localized charge transport polymer A, including at least the charge transport polymer B, are located at the other surface of the organic layer.

In other words, by using the charge transport material of this embodiment, the concentration of the charge transport polymer A at one surface of the organic layer can be increased, while the concentration of the charge transport polymer A at the other surface of the organic layer can be lowered. By utilizing this concentration difference in the charge transport polymer A, the organic layer can be imparted with two or more functions. For example, the organic layer may function as a hole injection layer and a hole transport layer, or as a hole transport layer and an electron blocking layer or the like.

Conventionally, in those cases where, for example, a hole injection layer and a hole transport layer are to be formed, it has been necessary to first form the hole injection layer on the electrode using a charge transport material for forming the hole injection layer, and then form the charge transport layer on top of the formed hole injection layer using a charge transport material for forming the hole transport layer. By using the charge transport material of the present embodiment, only a single organic layer need be formed, meaning problems such as oxidation of the surface of the hole injection layer and contamination of the interface by foreign matter during processing can be prevented. Further, it is thought that no clear interface exists between the region in which the charge transport polymer A is localized and the remaining region. Consequently, the organic layer formed using the charge transport material of the present embodiment exhibits properties including excellent charge transport properties and low electrical resistance. As a result, an improvement in the light emission efficiency, a reduction in the drive voltage and/or an improvement in the emission lifespan of organic EL elements can be achieved.

### [Charge Transport Polymer A]

The charge transport polymer A has at least one type of group selected from the group consisting of fluoroalkyl groups and fluoroaryl groups. The charge transport polymer A may have only one type of group selected from the group consisting of fluoroalkyl groups and fluoroaryl groups, or may have two or more types of such groups.

### (Fluoroalkyl Groups and Fluoroaryl Groups)

Examples of the fluoroalkyl groups include fluoroalkyl groups in which a portion of the hydrogen atoms contained in an alkyl group have each been substituted with a fluorine atom, and fluoroalkyl groups in which all of the hydrogen atoms have been substituted with fluorine atoms (namely, perfluoroalkyl groups). From the viewpoints of further reducing the surface energy and increasing the concentration difference, perfluoroalkyl groups are preferred.

The number of carbon atoms within the alkyl group may be 1 or greater, and from the viewpoint of solubility, is preferably at least 2, more preferably at least 3, even more preferably at least 4, and particularly preferably 5 or greater. Further, from the viewpoint of suppressing any reduction in the glass transition temperature, the number of carbon atoms within the alkyl group is preferably not more than 20, more preferably not more than 15, even more preferably not more than 10, and particularly preferably 7 or fewer. The alkyl group may be linear, branched or cyclic, but is preferably linear or branched. Specific examples of the alkyl group include a methyl group, ethyl group, propyl group, i-propyl group, butyl group, i-butyl group, t-butyl group, pentyl group, hexyl group, cyclohexyl group, heptyl group, octyl group, 2-ethylhexyl group, nonyl group, 3,7-dimethyloctyl group, decyl group, undecyl group, dodecyl group, tridecyl group, tetradecyl group and pentadecyl group.

Examples of the fluoroaryl groups include fluoroaryl groups in which a portion of the hydrogen atoms contained in an aromatic hydrocarbon group have each been substituted with a fluorine atom, and fluoroaryl groups in which all of the hydrogen atoms contained in an aromatic hydrocarbon group have been substituted with fluorine atoms (namely, perfluoroaryl groups). From the viewpoints of further reducing the surface energy and increasing the concentration difference, perfluoroaryl groups are preferred.

The number of carbon atoms within the aryl group may be 6 or greater, and from the viewpoint of maintaining solubility, is preferably not more than 30, more preferably not more than 22, and even more preferably 14 or fewer. Specific examples of the aryl group include monovalent aromatic hydrocarbon groups derived from benzene (1), naphthalene (2), fluorene (2), anthracene (3), tetracene (4), pentacene (5), phenanthrene (3), chrysene (4), triphenylene (4), tetraphene (4), pyrene (4), picene (5), pentaphene (5), perylene (5), pentahelicene (5), hexahelicene (6), heptahelicene (7), coronene (7), fluoranthene (3), acephenanthrylene (3), aceanthrene (3), aceanthrylene (3), pleiadene (4), tetraphenylene (4), cholanthrene (4), dibenzanthracene (5), benzopyrene (5), rubicene (5), hexaphene (6), hexacene (6), trinaphthylene (7), heptaphene (7), heptacene (7) and pyranthrone (8). The numbers in parentheses indicate the numbers of benzene rings contained in the aromatic hydrocarbons.

From the viewpoints of further reducing the surface energy and increasing the concentration difference, the charge transport polymer A preferably has at least a fluoroalkyl group.

Specific examples of the fluoroalkyl groups and fluoroaryl groups are shown below. In the present description, a wavy line in a formula indicates a bonding site to another structural unit.

### «Fluoroalkyl Group 1»

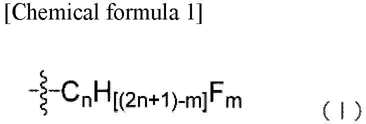

One example of the fluoroalkyl group is preferably represented by formula (I) shown above, which represents a substituent in which a portion of the hydrogen atoms of an alkyl group have each been substituted with a fluorine atom. The fluoroalkyl group may be linear, branched or cyclic, but is preferably linear or branched.

In the formula, m and n each represents an integer of 1 or greater, and (2n+1)>m.

From the viewpoint of achieving a favorable localization effect, n is preferably at least 2, more preferably at least 3, even more preferably at least 4, and particularly preferably 5 or greater. Further, from the viewpoint of achieving favorable solubility in solvents, n is preferably not more than 20, more preferably not more than 15, even more preferably not more than 10, and particularly preferably 7 or less.

Further, m is preferably 1 or greater, and from the viewpoint of achieving a favorable localization effect, is preferably at least 2, and more preferably 3 or greater. A larger value of m is preferable, with the upper limit being (2n), but if consideration is given to the wettability obtained when used as an ink composition or an organic layer, then m is preferably not more than 20, more preferably not more than 15, and even more preferably 10 or less.

### <<Fluoroalkyl Group 2 (Perfluoroalkyl Group)>>

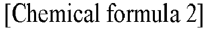

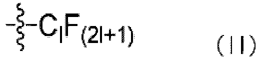

Another example of the fluoroalkyl group is preferably represented by formula (II) shown above, which represents a substituent (perfluoroalkyl group) in which all of the hydrogen atoms of an alkyl group have been substituted with fluorine atoms. The perfluoroalkyl group may be linear, branched or cyclic, but is preferably linear or branched.

In the formula, 1 represents an integer of 1 or greater, and from the viewpoint of achieving a favorable localization effect, is preferably at least 2, more preferably at least 3, even more preferably at least 4, and particularly preferably 5 or greater. Further, from the viewpoint of achieving favorable solubility in solvents, 1 is preferably not more than 20, more preferably not more than 15, even more preferably not more than 10, and particularly preferably 7 or less.

Examples are shown below.

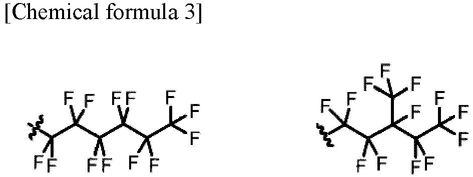

### <<Fluoroaryl Group>>

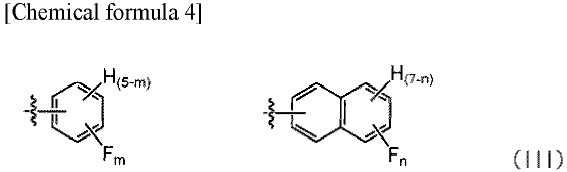

Examples of the fluoroaryl group are preferably represented by one of the formulas (III) shown above, which represent substituents in which a portion of the hydrogen atoms of an aromatic hydrocarbon group have each been substituted with a fluorine atom.

In the above formula, m is 1 or greater, and from the viewpoint of achieving a favorable localization effect, is preferably at least 2, and more preferably 3 or greater. A larger value of m is preferable, with the upper limit being 4, but if consideration is given to the wettability obtained when used as an ink composition or an organic layer, then m is preferably not more than 3, and more preferably 2 or less.

Further, n is 1 or greater, and from the viewpoint of achieving a favorable localization effect, is preferably at least 2, more preferably at least 3, and even more preferably 4 or greater. A larger value of n is preferable, with the upper limit being 6, but if consideration is given to the wettability obtained when used as an ink composition or an organic layer, then n is preferably not more than 5, and more preferably 4 or less.

### <<Fluoraryl Group 2 (Perfluoroaryl Group)>>

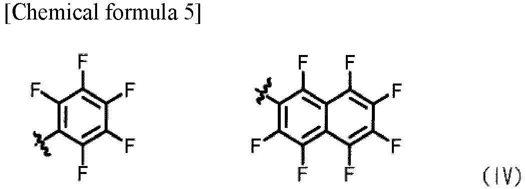

Other examples of the fluoroaryl group are preferably represented by one of the formulas (IV) shown above, which represent substituents (perfluoroaryl groups) in which all of the hydrogen atoms of an aromatic hydrocarbon group have been substituted with fluorine atoms.

The fluoroalkyl group or fluoroaryl group may be introduced at a terminal portion of the charge transport polymer A (namely, a structural unit T described below), may be introduced at a portion other than a terminal portion (namely, a structural unit L or B described below), or may be introduced at both a terminal portion and a portion other than a terminal. From the viewpoint of enabling favorable formation of an organic layer in which the charge transport polymer A and the charge transport polymer B are localized, the fluoroalkyl group and/or fluoroaryl group is preferably introduced at least at a terminal portion, and from the viewpoint of maintaining wettability obtained when used as an ink composition or an organic layer, is preferably introduced only at terminal portions. Furthermore, in those cases where the charge transport polymer A has a branched structure, the fluoroalkyl group and fluoroaryl group may be introduced within the main chain, introduced within a side chain, or introduced within both the main chain and a side chain.

### (Structure)

The charge transport polymer A is a polymer that has the ability to transport an electric charge, and there are no particular limitations on the structure of the polymer. The charge transport polymer A is preferably a polymer that has the ability to transport positive holes.

The charge transport polymer A may be a linear polymer, or a branched polymer with a branched structure. From the viewpoint of facilitating more precise control of the molecular weight and the physical properties of the ink composition, a linear polymer is preferred, whereas from the viewpoint of enabling the molecular weight to be increased more easily, a branched polymer is preferred. A branched polymer is also preferred from the viewpoint of enhancing the durability of the organic electronic element.

A linear charge transport polymer A has no branch points on the polymer chain, and has two terminals. The linear charge transport polymer A contains a divalent structural unit L that forms the polymer chain, and a monovalent structural unit T that forms the terminal portion. A branched charge transport polymer A has a branch point on the polymer chain, and has three or more terminals. The branched charge transport polymer A contains a trivalent structural unit B that forms the branch point and a monovalent structural unit T that forms the terminal portion, and may also contain a divalent structural unit L. The branched charge transport polymer A has a main chain and a branch chain (side chain), and the side chain contains either one, or two or more, structural units. In the charge transport polymer A, the various structural units are bonded together at "monovalent" to "trivalent or higher" bonding sites.

Examples of the structural unit L, the structural unit T and the structural unit B are described below. The structural unit L, the structural unit T and the structural unit B are charge transport groups, and have the ability to transport an electric charge. The charge transport polymer A may have one type, or two or more types, of each of the structural unit L, the structural unit T and the structural unit B. The charge transport polymer A has a structural unit having at least one type of group selected from the group consisting of fluoroalkyl groups and fluoroaryl groups as at least one type of structural unit L, structural unit T or structural unit B.

Examples of partial structures contained in the charge transport polymer A are described below. However, the charge transport polymer A is not limited to polymers having the following partial structures. In the partial structures, "L" represents a structural unit L, "B" represents a structural unit B, and "T" represents a structural unit T. In the present description, an "*" in a formula represents a bonding site for bonding to another structural unit. In the following partial structures, the plurality of L structural units may be structural units having the same structure or structural units having mutually different structures. This also applies for the B and T structural units. The partial structures include a structural unit having at least one type of group selected from the group consisting of fluoroalkyl groups and fluoroaryl groups as at least one type of "L", "B" or "T" unit.

### <<Partial Structures of Linear Charge Transport Polymers A>>

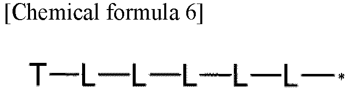

### <<Partial Structures of Branched Charge Transport Polymers A>>

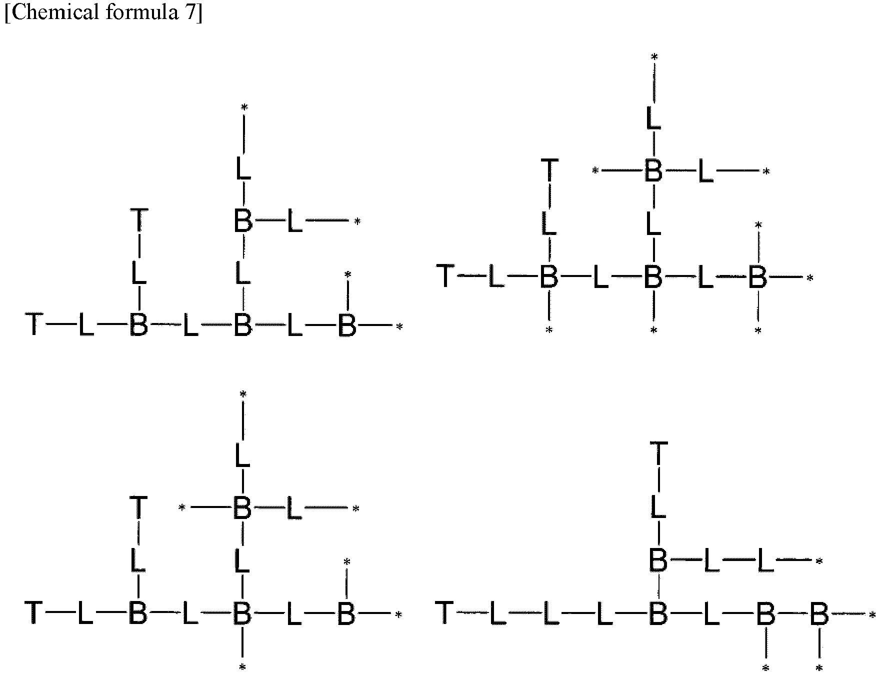

### (Structural Unit L)

The structural unit L is a divalent structural unit having charge transport properties. There are no particular limitations on the structural unit L, provided it includes an atom grouping having the ability to transport an electric charge. For example, the structural unit L may be selected from among aromatic amine structures, carbazole structures, thiophene structures, fluorene structures, benzene structures, biphenyl structures, terphenyl structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, and benzotriazole structures, which may be substituted or unsubstituted, and structures containing one type, or two or more types, of the above structures. The aromatic amine structures are preferably triarylamine structures, and more preferably triphenylamine structures.

In one embodiment, from the viewpoint of obtaining superior hole transport properties, the structural unit L is preferably selected from among aromatic amine structures, carbazole structures, thiophene structures, fluorene structures, benzene structures, and pyrrole structures, which may be substituted or unsubstituted, and structures containing one type, or two or more types, of these structures, and is more preferably selected from among substituted or unsubstituted aromatic amine structures, substituted or unsubstituted carbazole structures, and structures containing one type, or two or more types, of these structures. In another embodiment, from the viewpoint of obtaining superior electron transport properties, the structural unit L is preferably selected from among fluorene structures, benzene structures, phenanthrene structures, pyridine structures, and quinoline structures, which may be substituted or unsubstituted, and structures containing one type, or two or more types, of these structures.

Specific examples of the structural unit L are shown below. However, the structural unit L is not limited to the following structures.

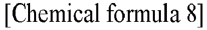

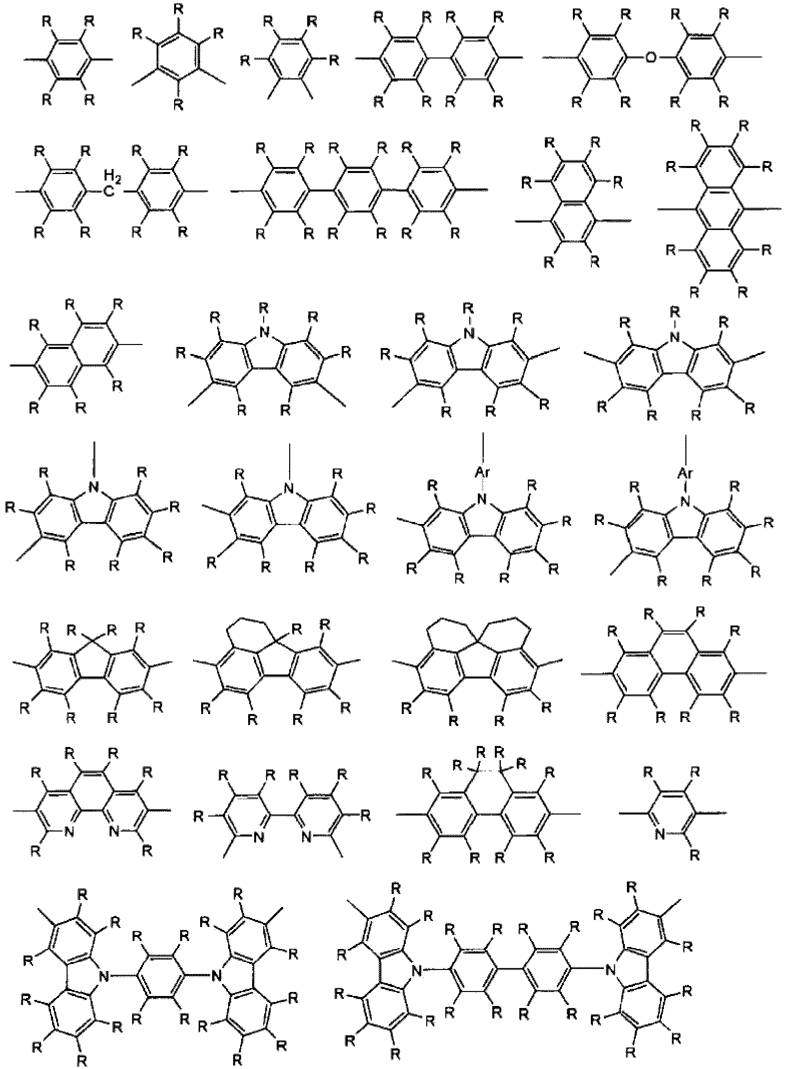

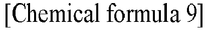

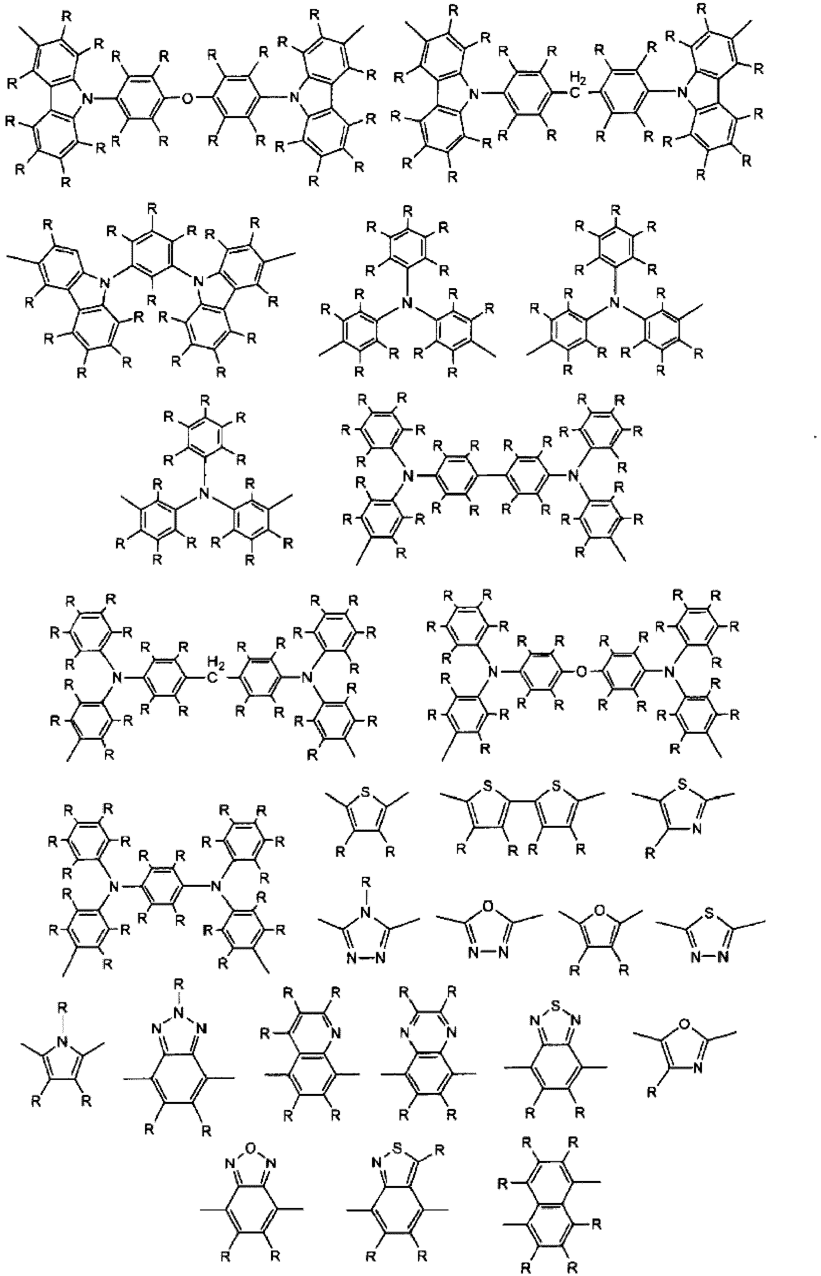

Each R independently represents a hydrogen atom or a substituent. It is preferable that each R is independently selected from a group consisting of -R¹, -OR², -SR³, -OCOR⁴, -COOR⁵, -SiR⁶R⁷R⁸, halogen atoms, groups containing a fluoroalkyl group, groups containing a fluoroaryl group, and groups containing a polymerizable functional group described below. Each of R¹ to R⁸ independently represents a hydrogen atom, a linear, cyclic or branched alkyl group of 1 to 22 carbon atoms, or an aryl group or heteroaryl group of 2 to 30 carbon atoms. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. In the above specific examples, the charge transport polymer A becomes a compound having a fluoroaryl group in those cases where R represents a fluorine atom. R is preferably a hydrogen atom, an alkyl group, an aryl group, or an alkyl-substituted aryl group. Ar represents an arylene group or heteroarylene group of 2 to 30 carbon atoms. Ar is preferably an arylene group, and is more preferably a phenylene group.

An aryl group is an atom grouping in which one hydrogen atom has been removed from an aromatic hydrocarbon. A heteroaryl group is an atom grouping in which one hydrogen atom has been removed from an aromatic heterocycle. An arylene group is an atom grouping in which two hydrogen atoms have been removed from an aromatic hydrocarbon. A heteroarylene group is an atom grouping in which two hydrogen atoms have been removed from an aromatic heterocycle. Examples of the aromatic hydrocarbon include monocyclic rings, condensed rings, and polycyclic rings in which two or more rings selected from among monocyclic rings and condensed rings are bonded together via single bonds. Examples of the aromatic heterocycles include monocyclic rings, condensed rings, and polycyclic rings in which two or more rings selected from among monocyclic rings and condensed rings are bonded together via single bonds.

The groups containing a fluoroalkyl group are, for example, represented by formula (V) shown below.
[Chemical formula 10]

-X-R^{f} (V)

R^{f} represents a fluoroalkyl group, and X represents a divalent linking group.

The groups containing a fluoroaryl group are, for example, represented by formula (VI) shown below.
[Chemical formula 11]

-X-Ar^{f} (VI)

Ar^{f} represents a fluoroaryl group, and X represents a divalent linking group.

Examples of X include a single bond, or a group containing at least one type of linking group selected from the group of linking groups represented by the formulas shown below.

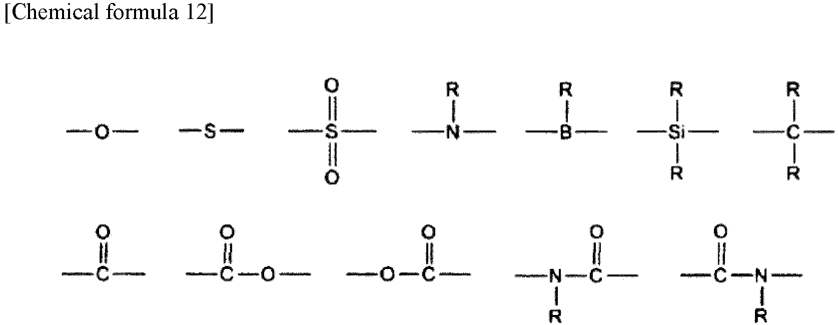

Each R independently represents a hydrogen atom or a substituent, and it is preferable that each R independently represents a hydrogen atom, a linear, cyclic or branched alkyl group of 1 to 22 carbon atoms, or an aryl group or heteroaryl group of 2 to 30 carbon atoms.

X is preferably a linking group represented by one of the following formulas.

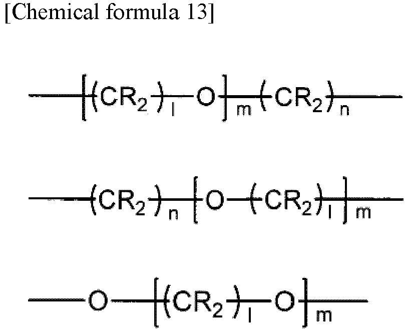

Each of l, m and n independently represents an integer of 0 or greater.

From the viewpoint of improving the solubility, 1 is preferably at least 1, and is more preferably 2 or greater. Further, from the viewpoint of maintaining the glass transition temperature, 1 is preferably not more than 30, more preferably not more than 25, even more preferably not more than 20, particularly preferably not more than 15, and most preferably 10 or less.

From the viewpoint of maintaining the glass transition temperature, m is preferably not more than 4, more preferably not more than 3, even more preferably not more than 2, and is particularly preferably either 1 or 2.

From the viewpoint of improving the solubility, n is preferably at least 1. Further, from the viewpoint of maintaining the glass transition temperature, n is preferably not more than 30, more preferably not more than 25, even more preferably not more than 20, particularly preferably not more than 15, and most preferably 10 or less.

Each R independently represents a hydrogen atom, a linear, cyclic or branched alkyl group of 1 to 22 carbon atoms, or an aryl group or heteroaryl group of 2 to 30 carbon atoms. R is preferably a hydrogen atom.

### (Structural Unit B)

The structural unit B is a trivalent or higher structural unit that forms a branched portion in those cases where the charge transport polymer A has a branched structure. From the viewpoint of improving the durability of the organic electronic element, the structural unit B is preferably not higher than hexavalent, and is more preferably either trivalent or tetravalent. The structural unit B is preferably a unit that has charge transport properties. For example, from the viewpoint of improving the durability of the organic electronic element, the structural unit B is preferably selected from among aromatic amine structures, carbazole structures, and condensed polycyclic aromatic hydrocarbon structures, which may be substituted or unsubstituted, and structures containing one type, or two or more types, of these structures. The structural unit B may have a similar structure to the structural unit L, or may have a different structure.

Specific examples of the structural unit B are shown below. However, the structural unit B is not limited to the following structures.

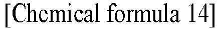

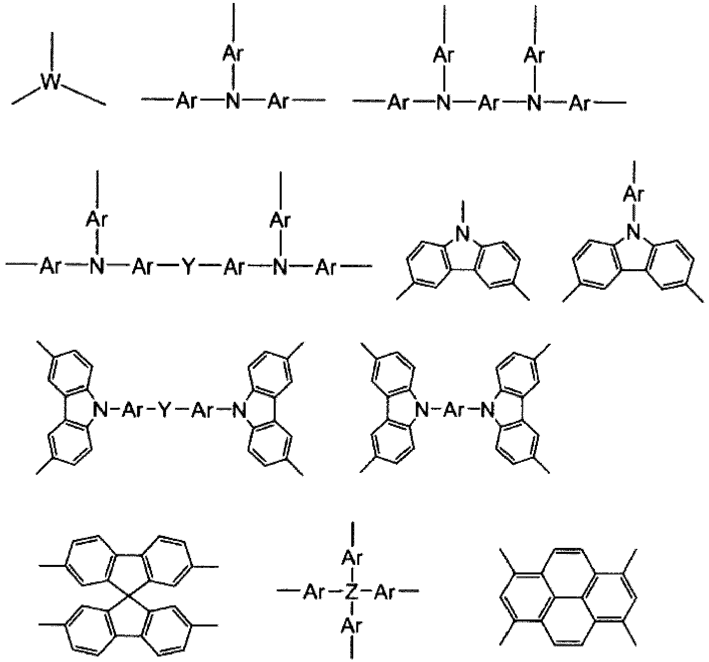

W represents a trivalent linking group, and for example, represents an arenetriyl group or heteroarenetriyl group of 2 to 30 carbon atoms. Each Ar independently represents a divalent linking group, and for example, may represent an arylene group or heteroarylene group of 2 to 30 carbon atoms. Ar is preferably an arylene group, and more preferably a phenylene group. Y represents a divalent linking group, and examples include divalent groups in which an additional hydrogen atom has been removed from any of the R groups having one or more hydrogen atoms (but excluding groups containing a polymerizable functional group) described in relation to the structural unit L. Z represents a carbon atom, a silicon atom or a phosphorus atom. In the structural units, the benzene rings and Ar groups may have a substituent, and examples of the substituent include the R groups in the structural unit L.

An arenetriyl group is an atom grouping in which three hydrogen atoms have been removed from an aromatic hydrocarbon. A heteroarenetriyl is an atom grouping in which three hydrogen atoms have been removed from an aromatic heterocycle. The aromatic hydrocarbon and aromatic heterocycle are as described above.

### (Structural Unit T)

The structural unit T is a monovalent structural unit that forms a terminal portion of the charge transport polymer A. There are no particular limitations on the structural unit T, which may be selected from among aromatic hydrocarbon structures and aromatic heterocyclic structures, which may be substituted or unsubstituted, and structures containing one type, or two or more types, of these structures. In one embodiment, from the viewpoint of imparting durability without impairing the charge transport properties, the structural unit T is preferably a substituted or unsubstituted aromatic hydrocarbon structure, and is more preferably a substituted or unsubstituted benzene structure. Further, in another embodiment, when the charge transport polymer A has a polymerizable functional group at a terminal portion in the manner described below, the structural unit T may be a polymerizable structure (for example, a polymerizable functional group such as a pyrrolyl group). The structural unit T may have a similar structure to the structural unit L, or may have a different structure, and may have a similar structure to the structural unit B, or may have a different structure.

A specific example of the structural unit T is shown below. However, the structural unit T is not limited to the structure below.

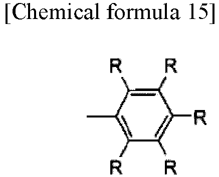

R is the same as R described in relation to the structural unit L. In those cases where the charge transport polymer A has at least one type of group selected from the group consisting of fluoroalkyl groups and fluoroaryl groups described below at a terminal portion, it is preferable that at least one R is a group represented by formula (V) or a group represented by formula (VI). Further, in those cases where the charge transport polymer A has a polymerizable functional group described below at a terminal portion, it is preferable that at least one R is a group containing a polymerizable functional group.

### (Polymerizable Functional Group)

From the viewpoint of enabling the polymer to be cured by a polymerization reaction, thereby changing the solubility in solvents, the charge transport polymer A may have at least one polymerizable functional group (also referred to as a "polymerizable substituent"). A "polymerizable functional group" is a group which is able to form bonds upon the application of heat and/or light.

Examples of the polymerizable functional group include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and siloyl group). Particularly preferred polymerizable functional groups include a vinyl group, acryloyl group, methacryloyl group, epoxy group and oxetane group, and from the viewpoints of the reactivity and the characteristics of the organic electronic element, a vinyl group, oxetane group or epoxy group is more preferred, and an oxetane group is even more preferred.

From the viewpoints of increasing the degree of freedom associated with the polymerizable functional group and facilitating the polymerization reaction, the main backbone of the charge transport polymer A and the polymerizable functional group are preferably linked, for example, via a linear alkylene chain of 1 to 8 carbon atoms. Further, in the case where, for example, the organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. Moreover, from the viewpoint of simplifying preparation of the monomer used for introducing the polymerizable functional group, the charge transport polymer A may have an ether linkage or an ester linkage at the terminal portion of the alkylene chain and/or the hydrophilic chain, namely, at the linkage site between these chains and the polymerizable functional group, and/or at the linkage site between these chains and the backbone of the charge transport polymer A. The aforementioned "group containing a polymerizable functional group" means either a polymerizable functional group itself, or a group containing a combination of a polymerizable functional group and an alkylene chain or the like.

The polymerizable functional group may be introduced at a terminal portion of the charge transport polymer A (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at a terminal portion. Further, in those cases where the charge transport polymer A has a branched structure, the polymerizable functional group may be introduced within the main chain of the charge transport polymer A, within a side chain, or within both the main chain and side chain.

From the viewpoint of contributing to a change in the solubility, the polymerizable functional group is preferably included in a large amount within the charge transport polymer A. On the other hand, from the viewpoint of not impeding the charge transport properties, the amount included in the charge transport polymer A is preferably kept small. The amount of the polymerizable functional group may be set as appropriate with due consideration of these factors.

For example, from the viewpoint of obtaining a satisfactory change in the solubility, the number of polymerizable functional groups per one molecule of the charge transport polymer A is preferably at least 2, and more preferably 3 or greater. Further, from the viewpoint of maintaining good charge transport properties, the number of polymerizable functional groups is preferably not more than 1,000, and more preferably 500 or fewer.

The number of polymerizable functional groups per one molecule of the charge transport polymer A can be determined as an average value, using the amount of the polymerizable functional group used in synthesizing the charge transport polymer A (for example, the amount added of the monomer having the polymerizable functional group), the amounts added of the monomers corresponding with the various structural units, and the weight average molecular weight of the charge transport polymer A and the like. Further, the number of polymerizable functional groups can also be calculated as an average value using the ratio between the integral of the signal attributable to the polymerizable functional group and the integral of the total spectrum in the ¹H-NMR (nuclear magnetic resonance) spectrum of the charge transport polymer A, and the weight average molecular weight of the charge transport polymer A and the like. In terms of ease of calculation, if the amounts added of the various components are clear, then the number of polymerizable functional groups is preferably determined using these amounts.

### (Proportions of Structural Units)

In those cases where the charge transport polymer A includes the structural unit L, from the viewpoint of ensuring satisfactory charge transport properties, the proportion of the structural unit L, relative to the total of all the structural units, is preferably at least 10 mol%, more preferably at least 20 mol%, and even more preferably 30 mol% or higher. If the structural unit T and the optionally introduced structural unit B are also taken into consideration, then the proportion of the structural unit L is preferably not more than 95 mol%, more preferably not more than 90 mol%, and even more preferably 85 mol% or less.

In those cases where the charge transport polymer A includes the structural unit B, from the viewpoint of improving the durability of the organic electronic element, the proportion of the structural unit B, relative to the total of all the structural units, is preferably at least 1 mol%, more preferably at least 5 mol%, and even more preferably 10 mol% or higher. Further, from the viewpoints of suppressing any increase in viscosity and enabling more favorable synthesis of the charge transport polymer A, or from the viewpoint of ensuring satisfactory charge transport properties, the proportion of the structural unit B is preferably not more than 50 mol%, more preferably not more than 40 mol%, and even more preferably 30 mol% or less.

From the viewpoint of improving the characteristics of the organic electronic element, or from the viewpoint of suppressing any increase in viscosity and enabling more favorable synthesis of the charge transport polymer A, the proportion of the structural unit T contained in the charge transport polymer A, relative to the total of all the structural units, is preferably at least 5 mol%, more preferably at least 10 mol%, and even more preferably 15 mol% or higher. Further, from the viewpoint of ensuring satisfactory charge transport properties, the proportion of the structural unit T is preferably not more than 60 mol%, more preferably not more than 55 mol%, and even more preferably 50 mol% or less.

From the viewpoint of achieving a satisfactory localization effect, the proportion of the fluoroalkyl group and/or fluoroaryl group contained in the charge transport polymer A (the combined proportion in the case where the polymer contains both groups), relative to the total of all the structural units, is preferably at least 5 mol%, more preferably at least 10 mol%, and even more preferably 15 mol% or greater. Further, from the viewpoint of obtaining favorable charge transport properties, the proportion of the fluoroalkyl group and/or fluoroaryl group contained in the charge transport polymer A (the combined proportion in the case where the polymer contains both groups) is preferably not more than 80 mol%, more preferably not more than 70 mol%, and even more preferably 60 mol% or less. Here, the "proportion of the fluoroalkyl group and/or fluoroaryl group" refers to the proportion of structural units containing the fluoroalkyl group and/or the fluoroaryl group.

In those cases where the charge transport polymer A has a polymerizable functional group, from the viewpoint of ensuring efficient curing of the charge transport polymer A, the proportion of the polymerizable functional group, relative to the total of all the structural units, is preferably at least 0.1 mol%, more preferably at least 1 mol%, and even more preferably 3 mol% or higher. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units containing the polymerizable functional group.

Considering the balance between charge transport properties, durability and productivity and the like, in the case of a linear charge transport polymer A, the ratio (molar ratio) between the structural unit L and the structural unit T is preferably L:T = 100:(1 to 70), more preferably 100:(3 to 50), and even more preferably 100:(5 to 30). Further, in the case of a branched charge transport polymer A, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amount used of the monomer corresponding with that structural unit during synthesis of the charge transport polymer A. Further, the proportion of each structural unit can also be calculated as an average value using the integral of the spectrum attributable to the structural unit in the ¹H-NMR spectrum of the charge transport polymer A. In terms of ease of calculation, if the amount added of each monomer is clear, then the proportion of the structural unit is preferably determined using the amount added of the monomer.

### (Number Average Molecular Weight, Weight Average Molecular Weight)

The charge transport polymer A is not a compound that can be represented by a single molecular weight, and is usually a collection of molecules each having two or more structural units.

The number average molecular weight of the charge transport polymer A may be adjusted appropriately with due consideration of the solubility in solvents and the film formability and the like. From the viewpoint of ensuring superior charge transport properties, the number average molecular weight is preferably at least 500, and from the viewpoint of also achieving excellent heat resistance and film formability, is more preferably at least 1,000, even more preferably at least 2,000, particularly preferably at least 3,000, and most preferably 5,000 or greater. From the viewpoint of achieving more superior charge transport properties, the number average molecular weight is preferably at least 7,000, and even more preferably 10,000 or greater. Further, from the viewpoints of maintaining favorable solubility in solvents and facilitating the preparation of ink compositions, the number average molecular weight is preferably not more than 1,000,000, more preferably not more than 100,000, even more preferably not more than 70,000, particularly preferably not more than 50,000, and most preferably 30,000 or less.

Within the above numerical range, from the viewpoints of achieving better suppression of crystallization, improving the film formation stability, and obtaining favorable heat resistance, a number average molecular weight of 3,000 or greater is preferred. Ensuring a number average molecular weight of 3,000 or greater is also preferable in terms of suppressing any increase in drive voltage by increasing intermolecular charge transport during electric charge transport.

The weight average molecular weight of the charge transport polymer A can be adjusted appropriately with due consideration of the solubility in solvents and the film formability and the like. From the viewpoint of ensuring superior charge transport properties, the weight average molecular weight is preferably at least 2,000, more preferably at least 3,000, even more preferably at least 8,000, particularly preferably at least 10,000, and most preferably 20,000 or greater. Further, from the viewpoints of maintaining favorable solubility in solvents and facilitating the preparation of ink compositions, the weight average molecular weight is preferably not more than 1,000,000, more preferably not more than 700,000, even more preferably not more than 300,000, particularly preferably not more than 150,000, and most preferably 100,000 or less.

The number average molecular weight and the weight average molecular weight can be measured by gel permeation chromatography (GPC), using a calibration curve prepared using standard polystyrenes.

From the viewpoint of ensuring favorable solubility in solvents, the dispersity of the charge transport polymer A is preferably broad, and is preferably at least 1.5, more preferably at least 2.0, even more preferably at least 2.3, and particularly preferably 2.5 or greater. From the viewpoint of suppressing fluctuations in the properties of the organic layer, and from the viewpoint of enabling easier synthesis of the charge transport polymer A, the dispersity of the charge transport polymer A is preferably not more than 20.0, more preferably not more than 15.0, and even more preferably 10.0 or less.

The degree of polymerization n of the charge transport polymer A (the number of structural units) is preferably at least 30 but not more than 10,000, and is more preferably at least 50 but not more than 8,000. The degree of polymerization n is even more preferably at least 70 but not more than 6,000. A larger degree of polymerization n is preferred from the viewpoint of film formation stability, whereas a smaller degree of polymerization n is preferred from the viewpoint of solubility. The most suitable degree of polymerization n may be selected as appropriate with due consideration of these factors.

The degree of polymerization may be determined as an average value using the weight average molecular weight of the charge transport polymer A, the molecular weights of the various structural units, and the proportions of the various structural units.

### (Method for Producing Charge Transport Polymer A)

The charge transport polymer A of the present embodiment is preferably a polymer or copolymer of a monomer containing a structural unit having hole transport properties. The charge transport polymer A can be produced favorably by copolymerizing a monomer mixture containing one or more types of monomers containing the above structural unit L and one or more types of monomers containing the above structural unit T, and optionally containing a monomer containing the above structural unit B. The copolymer may be an alternating, random, block or graft copolymer, or may be a copolymer having an intermediate type structure, such as a random copolymer having block-like properties.

The charge transport polymer A can be produced by various synthesis methods, and there are no particular limitations. For example, conventional coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer A can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used.

By changing the concentration of the raw material monomer during synthesis of the polymer, the molecular weight (number average molecular weight and weight average molecular weight) of the produced charge transport polymer A can be altered. The lower the monomer concentration, the smaller the molecular weight of the charge transport polymer A becomes, and the higher the monomer concentration, the larger the molecular weight of the charge transport polymer A becomes.

Further, other examples of methods for altering the molecular weight include methods in which the reaction time is altered, methods in which the catalyst concentration is altered, and methods in which the blend ratio between the raw material monomers is altered.

### [Charge Transport Polymer B]

The charge transport polymer B has no fluoroalkyl groups and no fluoroaryl groups. With the exception of the description relating to the fluoroalkyl group and the fluoroaryl group, the above description relating to the charge transport polymer A can also be applied to the charge transport polymer B.

In other words, the charge transport polymer B is a polymer that has the ability to transport an electric charge, and is preferably a polymer that has the ability to transport positive holes. The charge transport polymer B may be a linear polymer, or a branched polymer having a branched structure. A linear charge transport polymer B contains a structural unit L and a structural unit T. A branched charge transport polymer B contains a structural unit B and a structural unit T, and may also contain a structural unit L. The R groups contained in the structural units of the charge transport polymer B are preferably each independently selected from the group consisting of -R¹, -OR², -SR³, -OCOR⁴,-COOR⁵, -SiR⁶R⁷R⁸, a chlorine atom, a bromine atom, an iodine atom, and groups containing a polymerizable functional group.

For example, in those cases where the charge transport material is used in the formation of a hole transport layer, from the viewpoint of enabling smooth transport of the electric charge, the charge transport polymer B preferably satisfies a relationship represented by the following formula relative to the charge transport polymer A.

### [Numerical formula 1]

Absolute value of HOMO level of charge transport polymer B ≤ absolute value of HOMO level of charge transport polymer A

Further, in those cases where the charge transport material is used in the formation of a hole transport layer, the charge transport polymer A and the charge transport polymer B preferably each have at least one type of structural unit selected from the group consisting of structural units containing an aromatic amine structure and structural units containing a carbazole structure.

### [Dopant]

The charge transport material may include optional additives, and for example, may include a dopant. There are no particular limitations on the dopant, provided a doping effect is achieved by adding the dopant to the charge transport material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopant used in the charge transport material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HCl, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbF₅, AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In those cases where the charge transport polymer A and/or the charge transport polymer B has a polymerizable functional group, in order to make it easier to change the solubility of the organic layer, the use of a compound that can function as a polymerization initiator for the polymerizable functional group as the dopant is preferred.

### [Other Optional Components]

The charge transport material may also contain charge transport low-molecular weight compounds, or other polymers or the like.

### [Contents]

From the viewpoint of obtaining favorable charge transport properties, the total amount of the charge transport polymer A and the charge transport polymer B in the charge transport material, relative to the total mass of the charge transport material, is preferably at least 50% by mass, more preferably at least 70% by mass, and even more preferably 80% by mass or greater. There are no particular limitations on the upper limit for the total amount of the charge transport polymer A and the charge transport polymer B, and the amount may be 100% by mass. If consideration is given to the inclusion of additives such as dopants, then the amount of the charge transport polymer A and the charge transport polymer B is typically not more than 95% by mass, or not more than 90% by mass or the like.

From the viewpoints of ensuring that the charge transport polymer A and the charge transport polymer B exist in good balance, and improving the charge transport properties, the ratio between the amounts of the charge transport polymer A and the charge transport polymer B (the mass ratio A/B) is preferably at least 2/8, more preferably at least 3/7, and even more preferably 4/6 or greater. Further, from the same viewpoints, the value of A/B is preferably not more than 8/2, more preferably not more than 7/3, and even more preferably 6/4 or less.

When a dopant is included, from the viewpoint of improving the charge transport properties of the charge transport material, the amount of the dopant relative to the total mass of the charge transport material is preferably at least 0.01% by mass, more preferably at least 0.1% by mass, and even more preferably 0.5% by mass or greater. Further, form the viewpoint of maintaining favorable film formability, the amount of the dopant relative to the total mass of the charge transport material is preferably not more than 50% by mass, more preferably not more than 30% by mass, and even more preferably 20% by mass or less.

### [Applications]

The charge transport material can be used favorably as an organic electronic material, an organic electroluminescent material, an organic photoelectric conversion element material, or an organic transistor material or the like.

### <Ink Composition>

The ink composition that represents an embodiment of the present invention contains the charge transport material of the embodiment described above, and a solvent capable of dissolving or dispersing the material. By using the ink composition, an organic layer can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

In those cases where water is used, in order to prevent residual water in the organic layer from causing any degradation of the organic electronic element, drying is preferably performed at a high temperature for a long time. Considering this issue, the solvent is preferably an organic solvent, and is more preferably an organic solvent having a boiling point of 100°C or lower.

### [Polymerization Initiator]

In those cases where the charge transport polymer A and/or the charge transport polymer B has a polymerizable functional group, the ink composition preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

From the viewpoints of ensuring that the charge transport polymer A and the charge transport polymer B exist in good balance, and improving the charge transport properties, the ratio between the amounts of the charge transport polymer A and the charge transport polymer B (the mass ratio A/B) is preferably at least 2/8, more preferably at least 3/7, and even more preferably 4/6 or greater. Further, from the same viewpoints, the value of A/B is preferably not more than 8/2, more preferably not more than 7/3, and even more preferably 6/4 or less.

From the viewpoint of obtaining a homogenous ink composition, the charge transport polymer A and the charge transport polymer B preferably have a structural unit containing the same backbone (namely, the same structure except for the substituents and the bonding sites to other structures). It is more preferable that the charge transport polymer A has at least one type of structural unit among structural units containing an aromatic amine structure and structural units containing a carbazole structure, and in those cases where the charge transport polymer A has a structural unit containing an aromatic amine structure, the charge transport polymer B preferably also has a structural unit containing an aromatic amine structure, whereas in those cases where the charge transport polymer B has a structural unit containing an carbazole structure, the charge transport polymer B preferably also has a structural unit containing an carbazole structure. However, the aromatic amine structures or carbazole structures contained in the charge transport polymer A and the charge transport polymer B may differ in terms of the substituents and the bonding sites to other structures. Using a homogenous ink composition is also preferable from the viewpoint of preventing in-plane aggregation of the charge transport polymer A and the charge transport polymer B within the organic layer.

The amount of the solvent in the ink composition can be determined with due consideration of the use of the composition in various application methods. For example, the amount of the solvent is preferably an amount that yields a ratio of the total of all the charge transport polymers relative to the solvent that is at least 0.1% by mass, more preferably at least 0.2% by mass, and even more preferably 0.5% by mass or greater. Further, the amount of the solvent is preferably an amount that yields a ratio of the total of all the charge transport polymers relative to the solvent that is not more than 20% by mass, more preferably not more than 15% by mass, and even more preferably 10% by mass or less.

### <Organic Layer>

The organic layer that represents an embodiment of the present invention contains the above charge transport material, wherein the charge transport polymer A is localized at one surface of the organic layer. The organic layer can be formed using the ink composition of the embodiment described above. Further, the method for producing an organic layer that represents another embodiment of the present invention includes a step of coating the ink composition. This production method may also include other optional steps such as a drying step and a curing step. By using the ink composition, an organic layer having a concentration difference can be formed favorably and easily by a coating method. For example, in the case where an organic layer A and an organic layer B are to be formed, in a conventional production method, the step of coating an ink composition needed to be conducted twice. However, by using the production method of this embodiment, an organic layer that has the functions of the organic layer A and the organic layer B can be formed by conducting the step of coating the ink composition only once. Confirmation that the organic layer has a concentration difference can be made, for example, by measurement of the contact angle between the organic layer surface and a liquid (such as water or diiodomethane), or by time-of-flight secondary ion mass spectrometry (TOF-SIMS) analysis or the like.

Examples of the coating method include conventional methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods. When the organic layer is formed by a coating method, the organic layer (coating layer) obtained following coating may be dried on a hotplate or in an oven to remove the solvent.

In those cases where the charge transport polymer A and/or the charge transport polymer B has a polymerizable functional group, the charge transport polymer A and/or the charge transport polymer B can be subjected to a polymerization reaction by performing light irradiation or a heat treatment or the like, thereby changing the solubility of the organic layer. By stacking organic layers having changed solubility levels, multilayering of an organic electronic element can be performed with ease.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

From the viewpoint of forming a large concentration difference within the organic layer, the charge transport polymer A preferably has a contact angle with water of at least 90°, more preferably at least 93°, and even more preferably 96° or greater. There are no particular limitations on the upper limit, but for example, the value is typically not more than 110°. Further, from the same viewpoint, the charge transport polymer A preferably has a contact angle with diiodomethane of at least 35°, more preferably at least 40°, and even more preferably 45° or greater. There are no particular limitations on the upper limit, but for example, the value is typically not more than 80°.

In order to increase the contact angle with water, the amount of the one or more groups selected from the group consisting of fluoroalkyl groups and fluoroaryl groups introduced into the charge transport polymer A may be increased.

From the viewpoint of forming a large concentration difference within the organic layer, the charge transport polymer B preferably has a contact angle with water of not more than 98°, more preferably not more than 96°, and even more preferably 94° or less. There are no particular limitations on the lower limit, but for example, the value is typically at least 80°. Further, from the same viewpoint, the charge transport polymer A preferably has a contact angle with diiodomethane of not more than 45°, more preferably not more than 40°, and even more preferably 35° or less. There are no particular limitations on the lower limit, but for example, the value is typically at least 20°.

In order to reduce the contact angle with water, it is necessary that no fluoroalkyl groups and no fluoroaryl groups are introduced into the charge transport polymer B.

The contact angles of the charge transport polymer A with water and diiodomethane are preferably larger than the contact angles of the charge transport polymer B with water and diiodomethane.

The difference between the contact angles with water for the charge transport polymer A and the charge transport polymer B is preferably at least 2°, more preferably at least 3°, and even more preferably 4° or greater. Further, the difference between the contact angles with diiodomethane for the charge transport polymer A and the charge transport polymer B is preferably at least 5°, more preferably at least 10°, and even more preferably 15° or greater.

The contact angles for the charge transport polymer A refer to the contact angles obtained by forming an organic layer formed from the charge transport polymer A using a coating solution containing only the charge transport polymer A and a solvent, and then measuring the contact angles of the formed organic layer. The measurement method for the contact angles is performed in accordance with the method described in the Examples. This also applies for the contact angles for the charge transport polymer B.

### <Organic Electronic Element>

The organic electronic element that represents one embodiment of the present invention has at least one or more of the organic layers of the embodiment described above. Examples of the organic electronic element include an organic EL element, an organic photoelectric conversion element, and an organic transistor and the like. The organic electronic element preferably has at least a structure in which the organic layer is disposed between a pair of electrodes. Further, the method for producing an organic electronic element that represents another embodiment of the present invention includes at least a step of coating the ink composition of the embodiment described above to form an organic layer.

### <Organic EL Element>

The organic EL element that represents one embodiment of the present invention has at least one or more of the organic layers of the embodiment described above. The organic EL element typically includes a light-emitting layer, an anode, a cathode and a substrate. If necessary, the organic EL element may also have other functional layers, including layers with hole transport properties such as a hole injection layer, hole transport layer or electron blocking layer; and layers with electron transport properties such as an electron injection layer, electron transport layer and hole blocking layer. Each layer may be formed by a vapor deposition method, or by a coating method. The organic EL element preferably has the aforementioned organic layer as the light-emitting layer or as another functional layer, more preferably has the organic layer as a functional layer, and even more preferably has the organic layer as at least one type of layer among a hole injection layer, a hole transport layer and an electron blocking layer. The organic layer may be imparted with two or more functions. Preferred combinations include the functions of a hole injection layer and a hole transport layer, and the functions of a hole transport layer and an electron blocking layer. Furthermore, the method for producing an organic EL element that represents another embodiment of the present invention includes at least a step of coating the ink composition of the embodiment described above to form an organic layer.

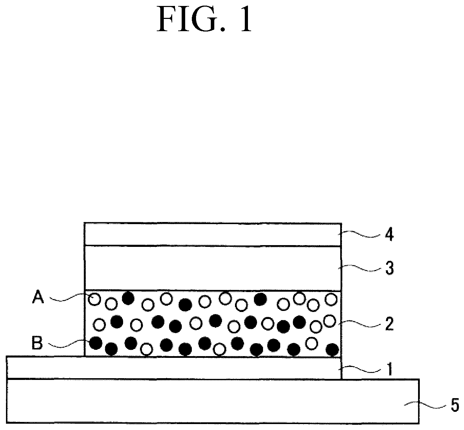

FIG. 1 is a schematic cross-sectional view illustrating one embodiment of the organic EL element. The organic EL element in FIG. 1 has an anode 1, an organic layer 2 of the embodiment described above, a light-emitting layer 3, and a cathode 4 provided in that order on a substrate 5. In FIG. 1, in order to represent the state of the concentration difference, the charge transport polymer A is indicated by white circles A and the charge transport polymer B is indicated by black circles B. The white circles B and the black circles A in FIG. 1 do not mean that the charge transport polymer A and the charge transport polymer B exist within the organic layer in a circular or spherical form.

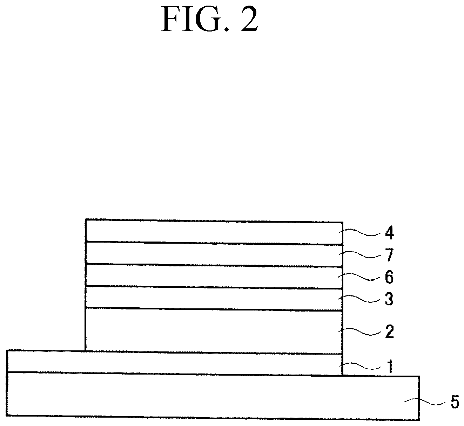

FIG. 2 is a schematic cross-sectional view illustrating another embodiment of the organic EL element. The organic EL element in FIG. 2 has an anode 1, an organic layer 2 of the embodiment described above, a light-emitting layer 3, an electron transport layer 6, an electron injection layer 7 and a cathode 4 provided in that order on a substrate 5.

Each of the above layers is described below.

### [Light-Emitting Layer]

Examples of the materials that can be used for the light-emitting layer include light-emitting materials such as low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the luminescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoqionoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the charge transport material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Transport Layer, Hole Injection Layer, and Electron Blocking Layer]

Examples of materials that can be used in hole transport layers, hole injection layers and electron blocking layers include the charge transport material of the embodiment described above. Further, the charge transport polymer A by itself, or the charge transport polymer B by itself, may also be used as the material used in a hole transport layer, hole injection layer or electron blocking layer.

Moreover, other examples of conventional materials include aromatic amine-based compounds (for example, aromatic diamines such as N,N'-di(naphthalen-1-yl)-N,N'-diphenyl-benzidine (a-NPD)), phthalocyanine-based compounds, and thiophene-based compounds (for example, thiophene-based conductive polymers (such as poly(3,4-ethylenedioxythiophene):poly(4-styrenesulfonate) (PEDOT:PSS) and the like).

### [Electron Transport Layer, Electron Injection Layer, and Hole Blocking Layer]

Examples of materials that can be used in electron transport layers, electron injection layers and hole blocking layers include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. Further, the charge transport material of the embodiment described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode. Examples of the other materials include oxides (for example, ITO: indium oxide/tin oxide), and conductive polymers (for example, polythiophene-polystyrene sulfonate mixtures (PEDOT:PSS)).

### [Substrate]

Glass and plastics and the like can be used as the substrate. The substrate is preferably transparent, and a flexible substrate having flexibility is preferred. Quartz glass and light-transmitting resin films and the like can be used particularly favorably.

Examples of the resin films include films containing polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Encapsulation]

The organic EL element may be encapsulated to reduce the effect of the outside atmosphere and extend the life of the element. Materials that can be used for the encapsulation include, but are not limited to, glass, plastic films such as epoxy resins, acrylic resins, polyethylene terephthalate and polyethylene naphthalate, and inorganic substances such as silicon oxide and silicon nitride.

There are no particular limitations on the encapsulation method, and conventional methods may be used.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may involve using a plurality of light-emitting materials to emit a plurality of colors simultaneously, and then mixing the emitted colors to obtain a white light emission. There are no particular limitations on the combination of the plurality of emission colors, and examples include combinations that include three maximum emission wavelengths for blue, green and red, and combinations that include two maximum emission wavelengths for blue and yellow, or yellowish green and orange or the like. Control of the emission color can be achieved by appropriate adjustment of the types and amounts of the light-emitting materials.

### <Display Element, Illumination Device, Display Device>

The display element that represents one embodiment of the present invention contains the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, the illumination device that represents one embodiment of the present invention contains the organic EL element of an embodiment of the present invention. Moreover, the display device that represents another embodiment of the present invention contains the illumination device and a liquid crystal element as a display unit. For example, the display device may be a device that uses the illumination device according to an embodiment of the present invention as a backlight, and uses a conventional liquid crystal element as the display unit, namely a liquid crystal display device.

### Examples

The present invention is described below in further detail using a series of examples, but the present invention is not limited by the following examples.

### <Preparation of Charge Transport Polymers>

Charge transport polymers were prepared in the manner described below.

### (Preparation of Pd Catalyst)

In a glove box under a nitrogen atmosphere and at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature to obtain a catalyst solution. All the solvents used in the catalyst preparation were deaerated by nitrogen bubbling for at least 30 minutes prior to use.

### (Production Example 1 - Charge Transport Polymer 1>

A three-neck round-bottom flask was charged with a monomer 1 shown below (2.0 mmol), a monomer 2 shown below (5.0 mmol), a monomer 3 shown below (4.0 mmol), and anisole (20 mL), and the prepared Pd catalyst solution (7.5 mL) was then added and stirred. After stirring for 30 minutes, a 10% aqueous solution of tetraethylammonium hydroxide (20 mL) was added to the flask. The resulting mixture was heated and refluxed for 2 hours. All the operations up to this point were conducted under a stream of nitrogen. Further, all of the solvents were deaerated by nitrogen bubbling for at least 30 minutes prior to use.

### [Chemical formula 16]

**Production Example 1**

| Monomer | Structural formula | Amount (mmol) | Solvent (mL) |
|---|---|---|---|
| 1 | 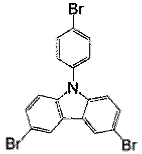 | 2.0 | 20 |
| 2 | 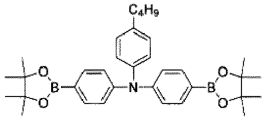 | 5.0 | |
| 3 | 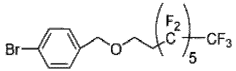 | 4.0 | |

After completion of the reaction, the organic layer was washed with water, and the organic layer was then poured into methanol-water (9:1). The resulting precipitate was collected by filtration, and then dried under vacuum to obtain a crude polymer. The thus obtained crude polymer was stirred in ethyl acetate (50 mL per 1.5 g of polymer mass) at 60°C for 30 minutes, and a hot filtration was then performed to remove low-molecular weight components. After repeating this operation three times, the polymer was dried. Following thorough drying, the polymer was dissolved in toluene to form a 10% by mass polymer solution. An amount of Scavenger Si-thiol (a 3-mercaptopropyl silica gel, manufactured by Biotage Japan Ltd.) equal to the mass of the polymer was added to the solution, and the resulting mixture was stirred at room temperature for at least 5 hours. Subsequently, the Si-thiol was removed by filtration through a polytetrafluoroethylene filter (pore diameter: 0.2 µm, 25JP020AN, manufactured by Advantec Co., Ltd.), and the filtrate was mixed with methanol to re-precipitate the polymer. The polymer was collected by filtration, and dried under vacuum in a desiccator, thus obtaining a purified charge transport polymer 1. The number average molecular weight and weight average molecular weight of the charge transport polymer 1 were measured under the conditions listed below, and the dispersity was determined.

The measurement conditions for the number average molecular weight and the weight average molecular weight were as follows.
Apparatus: High-performance liquid chromatograph "Prominence", manufactured by Shimadzu Corporation
   Feed pump (LC-20AD)
   Degassing unit (DGU-20A)
   Autosampler (SIL-20AHT)
   Column oven (CTO-20A)
   PDA detector (SPD-M20A)
   Refractive index detector (RID-20A)
Columns:
   Gelpack (a registered trademark)
   GL-A160S (product number: 686-1J27)
   GL-A150S (product number: 685-1J27)
   manufactured by Hitachi Chemical Co., Ltd.
Eluent: Tetrahydrofuran (THF) (for HPLC, contains stabilizers), manufactured by Wako Pure Chemical Industries, Ltd.
Flow rate: 1 mL/min
Column temperature: 40°C
Detection wavelength: 254 nm
Molecular weight standards: PStQuick A/B/C, manufactured by Tosoh Corporation

### (Production Example 2 - Charge Transport Polymer 2>

With the exception of adding a monomer 4 shown below (2.0 mmol), a monomer 2 shown below (5.0 mmol), a monomer 5 shown below (4.0 mmol) and anisole (20 mL) to a three-neck round-bottom flask, and then adding the prepared Pd catalyst solution (7.5 mL), a charge transport polymer 2 was obtained in the same manner as Production Example 1.

### [Chemical formula 17]

**Production Example 2**

| Monomer | Structural formula | Amount (mmol) | Solvent (mL) |
|---|---|---|---|
| 4 | 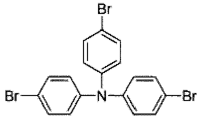 | 2.0 | 20 |
| 2 | 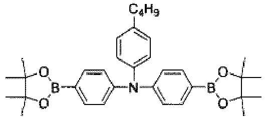 | 5.0 | |
| 5 | 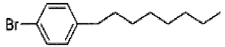 | 4. 0 | |

### (Production Example 3 - Charge Transport Polymer 3>

With the exception of adding a monomer 1 shown below (2.0 mmol), a monomer 2 shown below (5.0 mmol), a monomer 5 shown below (4.0 mmol) and anisole (8 mL) to a three-neck round-bottom flask, and then adding the prepared Pd catalyst solution (7.5 mL), a charge transport polymer 3 was obtained in the same manner as Production Example 1.

### [Chemical formula 18]

**Production Example 3**

| Monomer | Structural formula | Amount (mmol) | Solvent (mL) |
|---|---|---|---|
| 1 | 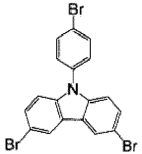 | 2.0 | 8 |
| 2 | 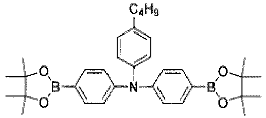 | 5.0 | |
| 5 | 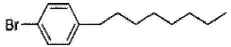 | 4.0 | |

### (Production Example 4 - Charge Transport Polymer 4>

With the exception of adding a monomer 1 shown below (2.0 mmol), a monomer 2 shown below (5.0 mmol), a monomer 3 shown below (4.0 mmol) and anisole (30 mL) to a three-neck round-bottom flask, and then adding the prepared Pd catalyst solution (7.5 mL), a charge transport polymer 4 was obtained in the same manner as Production Example 1.

### [Chemical formula 19]

**Production Example 4**

| Monomer | Structural formula | Amount (mmol) | Solvent (mL) |
|---|---|---|---|
| 1 | 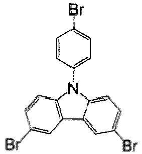 | 2.0 | 30 |
| 2 | 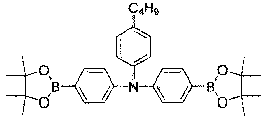 | 5.0 | |
| 3 | 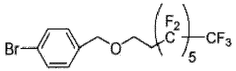 | 4.0 | |

### (Production Example 5 - Charge Transport Polymer 5>

With the exception of adding a monomer 4 shown below (2.0 mmol), a monomer 2 shown below (5.0 mmol), a monomer 6 shown below (4.0 mmol) and anisole (4 mL) to a three-neck round-bottom flask, a charge transport polymer 5 was obtained in the same manner as Production Example 1.

### [Chemical formula 20]

**Production Example 5**

| Monomer | Structural formula | Amount (mmol) | Solvent (mL) |
|---|---|---|---|
| 4 | 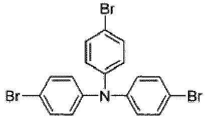 | 2.0 | 4 |
| 2 | 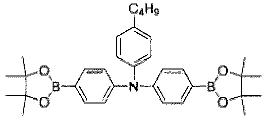 | 5.0 | |
| 6 | 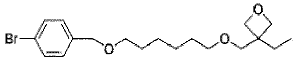 | 4.0 | |

### (Production Example 6 - Charge Transport Polymer 6>

With the exception of adding a monomer 7 shown below (4.0 mmol), a monomer 2 shown below (5.0 mmol), a monomer 3 shown below (2.0 mmol) and anisole (4 mL) to a three-neck round-bottom flask, and then adding the prepared Pd catalyst solution (7.5 mL), a charge transport polymer 6 was obtained in the same manner as Production Example 1.

### [Chemical formula 21]

**Production Example 6**

| Monomer | Structural formula | Amount (mmol) | Solvent (mL) |
|---|---|---|---|
| 7 | 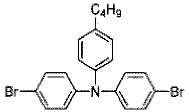 | 4.0 | 4 |
| 2 | 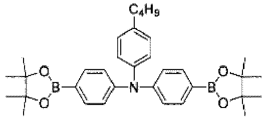 | 5.0 | |
| 3 | 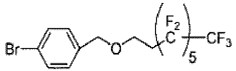 | 2.0 | |

### (Production Example 7 - Charge Transport Polymer 7>

With the exception of adding a monomer 8 shown below (2.0 mmol), a monomer 2 shown below (5.0 mmol), a monomer 3 shown below (4.0 mmol) and anisole (4 mL) to a three-neck round-bottom flask, a charge transport polymer 7 was obtained in the same manner as Production Example 1.

### [Chemical formula 22]

**Production Example 7**

| Monomer | Structural formula | Amount (mmol) | Solvent (mL) |
|---|---|---|---|
| 8 | 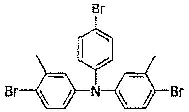 | 2.0 | 4 |
| 2 | 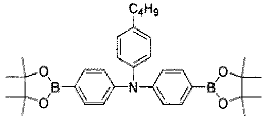 | 5.0 | |
| 3 | 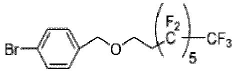 | 4. 0 | |

The number average molecular weight, weight average molecular weight and dispersity values for each of the charge transport polymers 1 to 7 are shown in Table 1.

### [Table 1]

**Table 1 Mw, Mn and dispersity values for synthesized charge transport polymers**

| Charge transport polymer | Mw | Mn | Dispersity |
|---|---|---|---|
| 1 | 57,900 | 9,300 | 6.2 |
| 2 | 67,400 | 13,000 | 5.2 |
| 3 | 72,200 | 5,200 | 13.9 |
| 4 | 2,800 | 900 | 3.1 |
| 5 | 78,600 | 8,200 | 9.6 |
| 6 | 9,500 | 4,700 | 2.0 |
| 7 | 69,800 | 17,000 | 4.1 |

### <Example 1 Formation and Evaluation of Organic Layers>

Organic layers were formed in the manner described below, and the surface contact angles of each organic layer were evaluated.

### [Organic Layer E1]

The charge transport polymer 1 (1.0 mg), the charge transport polymer 3 (19.0 mg) and toluene (750 µL) were mixed together to prepare a coating solution. The thus obtained coating solution was then spin-coated at a rotational rate of 3,000 min⁻¹ onto a glass substrate (22 mm × 28 mm × 1 mm) on which ITO had been patterned with a width of 1.6 mm.

The glass substrate was then heated on a hotplate at 180°C for 10 minutes in a dry nitrogen atmosphere, thus forming an organic layer E1 (thickness: 50 nm).

The surface of the formed organic layer E1 was evaluated using the following procedure. Evaluation was performed using a contact angle meter (DropMaster 500, manufactured by manufactured by Kyowa Interface Science Co., Ltd.), by measuring the contact angles for pure water and diiodomethane on the organic layer.

In an open atmosphere and at room temperature (25°C), 1 µL of pure water (25°C) or diiodomethane (25°C) was discharged from the needle tip of a syringe (provided as a standard accessory for the DropMaster 500), thus forming a liquid droplet at the needle tip. The needle tip was then moved closer to the organic layer until the liquid droplet touched the organic layer. When the liquid droplet touched the organic layer, the syringe was withdrawn away from the organic layer. Ten seconds after liquid contact (after the liquid droplet had contacted the organic layer), an image analysis of the liquid droplet was performed, the contact angle was determined by the θ/2 method, and the average of four measurements was calculated.

### [Organic Layer C1]

A coating solution prepared by mixing the charge transport polymer 1 (20.0 mg) and toluene (750 µL) was spin-coated at a rotational rate of 3,000 min⁻¹ onto a glass substrate on which ITO had been patterned with a width of 1.6 mm. Subsequent operations were performed in the same manner as Example 1 to form an organic layer C1 (thickness: 50 nm), and then perform measurement of the contact angles.

### [Organic Layer C2]

A coating solution prepared by mixing the charge transport polymer 3 (20.0 mg) and toluene (750 µL) was spin-coated at a rotational rate of 3,000 min⁻¹ onto a glass substrate on which ITO had been patterned with a width of 1.6 mm. Subsequent operations were performed in the same manner as Example 1 to form an organic layer C2 (thickness: 50 nm), and then perform measurement of the contact angles.

### [Table 2]

**Table 2 Results of contact angle measurements**

| Organic layer | Contact angle of water (degrees) | Contact angle of diiodomethane (degrees) |
|---|---|---|
| E1 | 96.5 | 60.1 |
| C1 | 96.6 | 62.1 |
| C2 | 88.3 | 34.9 |

In the case of the organic layer E1, the organic layer was produced by mixing the charge transport polymer 1 and the charge transport polymer 3 in a ratio of 5:95. Despite the fact that the abundance ratio of the charge transport polymer 1 in the coating solution was only 5% by mass, the contact angles values were substantially the same as the values for the organic layer C1 formed solely from the charge transport polymer 1. Based on this result, it can be stated that the charge transport polymer 1 is localized at the surface of the organic layer, and that a concentration difference has developed spontaneously within the organic layer E1.

### <Example 2 Production of Organic EL Elements and Evaluation of Properties>

### [Organic EL Element E1]

A coating solution prepared by mixing the charge transport polymer 1 (2.0 mg), the charge transport polymer 2 (2.5 mg) and toluene (500 µL) was spin-coated at a rotational rate of 3,000 min⁻¹ onto a glass substrate on which ITO had been patterned with a width of 1.6 mm. All subsequent operations were performed under a dry nitrogen atmosphere.

Next, the coating solution was dried on a hotplate at 180°C for 10 minutes, thus forming a hole transport layer (40 nm).

Subsequently, the obtained glass substrate was transferred into a vacuum deposition apparatus, and CBP+Ir(ppy)₃ (40 nm), BAlq (10 nm), Alq₃ (30 nm), LiF (thickness: 0.5 nm) and Al (thickness: 100 nm) were deposited sequentially onto the substrate.

Following formation of the electrode, the glass substrate was transferred into a dry nitrogen atmosphere without exposure to the external atmosphere, and an encapsulation was performed by using a photocurable epoxy resin to bond the glass substrate to an encapsulating glass having a countersink of 0.4 mm formed in an alkali-free glass with a thickness of 0.7 mm, thus completing production of an organic EL element E1 having a multilayer structure.

Further, a separate hole transport layer prepared using the same method as that described above was evaluated for the existence or absence of localization of the charge transport polymer 1 using the same evaluation method as that described above in <Example 1 Formation and Evaluation of Organic Layers>.

### [Organic EL Element C1, and Organic EL Elements E2 to E5]

With the exceptions of altering the charge transport polymers to the charge transport polymers shown in Table 3, and in the case of the organic EL element E5, also adding an ionic compound I shown below to the coating solution, an organic EL element C1 and organic EL elements E2 to E5 were produced in the same manner as the organic EL element E1. Further, the hole transport layer was also evaluated for the existence or absence of localization of the charge transport polymer A in the same manner as that described for the organic EL element E1.

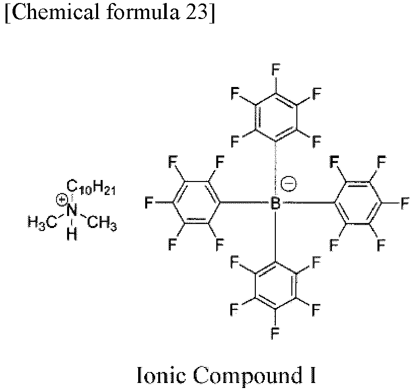

### [Table 3]

**Table 3 Formulations of Ink Compositions**

| Organic EL element | Charge transport polymer | Charge transport polymer | Ionic compound |
|---|---|---|---|
| C1 | 3 | 2 | - |
| | 2.0 mg | 2.5 mg | |
| E1 | 1 | 2 | - |
| | 2.0 mg | 2.5 mg | |
| E2 | 4 | 2 | - |
| | 2.0 mg | 2.5 mg | |
| E3 | 6 | 2 | - |
| | 2.0 mg | 2.5 mg | |
| E4 | 7 | 2 | - |
| | 2.0 mg | 2.5 mg | |
| E5 | 7 | 2 | I |
| | 2.0 mg | 2.5 mg | 0.13 mg |

Each of the organic EL elements was transferred into an open atmosphere, and the element properties were evaluated at room temperature (25°C). The evaluation results are shown in Table 4.

When a voltage was applied to each of the organic EL elements C1 and E1 to E5, a green light emission was confirmed in each case. For each of these organic EL elements, the emission efficiency (current efficiency) at an emission luminance of 1,000 cd/m² was measured. The emission luminance was measured using a luminance meter (Pritchard 1980B, manufactured by Photo Research Inc.).

### [Table 4]

**Table 4 Element Evaluation Results**

| Organic EL element | Existence of localization | Emission efficiency (cd/A) |
|---|---|---|
| C1 | - | 10.4 |
| E1 | yes | 20.9 |
| E2 | yes | 11.5 |
| E3 | yes | 19.6 |
| E4 | yes | 21.2 |
| E5 | yes | 19.2 |

Based on the confirmation of the localization of the charge transport polymer A, it was evident that the hole transport layer had a region that exhibited a function as a hole transport layer (a region in which the concentration of the charge transport polymer A was high), and a region that exhibited a function as a hole injection layer (a region in which the charge transport polymer A was not localized and in which the concentration of the charge transport polymer B was high). As is evident from Table 4, in the organic EL elements E1 to E5, as a result of the localization of the charge transport polymer A, the emission efficiency improved compared with that of the organic EL element C1.

### <Example 3 Evaluation of Properties of Organic EL Elements>

For the organic EL elements E1 and E2, the drive voltage and the emission lifespan were also measured. The current-voltage characteristics were measured using a microammeter (4140B, manufactured by The Hewlett-Packard Company). Further, the emission lifespan was measured by using a luminance meter (BM-7, manufactured by Topcon Corporation) to measure the luminance while a constant current was applied, and determining the time taken for the luminance to decrease by 30% from the initial luminance (5,000 cd/m²) (the time required to reach a luminance of initial luminance × 0.7). The evaluation results are shown in Table 5.

### [Table 5]

**Table 5 Element Evaluation Results**

| Organic EL element | Emission efficiency (cd/A) | Drive voltage (V) | Emission lifespan (h) |
|---|---|---|---|
| E1 | 20.9 | 7.0 | 98.6 |
| E2 | 11.5 | 9.5 | 35.2 |

As is evident from Table 5, because the molecular weight of the charge transport polymer A in the organic EL element E1 was large, compared with the organic EL element E2, the results obtained revealed a high emission efficiency, a low drive voltage, and an excellent emission lifespan.

### <Example 4 Production of Organic EL Element and Evaluation of Properties>

### [Organic EL Element C2]

A coating solution prepared by mixing the charge transport polymer 5 (2.0 mg), the above ionic compound I (0.13 mg) and toluene (500 µL) was spin-coated at a rotational rate of 3,000 min⁻¹ onto a glass substrate on which ITO had been patterned with a width of 1.6 mm.

Next, the coating solution was cured in a dry nitrogen atmosphere by heating on a hotplate at 180°C for 10 minutes, thus forming a hole injection layer (40 nm).

A coating solution prepared by mixing the charge transport polymer 1 (2.5 mg) and toluene (500 µL) was then spin-coated onto the obtained hole injection layer at a rotational rate of 3,000 min⁻¹.

Subsequently, the coating solution was dried in a dry nitrogen atmosphere by heating on a hotplate at 180°C for 10 minutes, thus forming a hole transport layer (40 nm).

Next, the obtained glass substrate was transferred into a vacuum deposition apparatus, and CBP+Ir(ppy)₃ (40 nm), BAlq (10 nm), Alq₃ (30 nm), LiF (thickness: 0.5 nm) and Al (thickness: 100 nm) were deposited sequentially onto the substrate.

Following formation of the electrode, the glass substrate was transferred into a dry nitrogen atmosphere without exposure to the external atmosphere, and an encapsulation was performed by using a photocurable epoxy resin to bond the glass substrate to an encapsulating glass having a countersink of 0.4 mm formed in an alkali-free glass with a thickness of 0.7 mm, thus completing production of an organic EL element having a multilayer structure.

When a voltage was applied to the organic EL element C2, a green light emission was confirmed. The emission efficiency (current efficiency) of the organic EL element C2 was measured using the same method as that described above. Further, for each of the organic EL elements E1, E3 to E5 and C2, the drive voltage and the emission lifespan were also measured using the same methods as described above. The evaluation results are shown in Table 6.

### [Table 6]

**Table 6 Element Evaluation Results**

| Organic EL element | Emission efficiency (cd/A) | Drive voltage (V) | Emission lifespan (h) |
|---|---|---|---|
| C2 | 16.5 | 7.4 | 68.4 |
| E1 | 20.9 | 7.0 | 98.6 |
| E3 | 19.6 | 7.6 | 80.7 |
| E4 | 21.2 | 7.3 | 99.7 |
| E5 | 19.2 | 6.5 | 100.7 |

As is evident from Table 6, in the organic EL elements E1 and E3 to E5, because the charge transport polymer A was localized and the molecular weight of the charge transport polymer A was large, the results obtained revealed a high emission efficiency, a low drive voltage, and an excellent emission lifespan.

### Reference Signs List

1: Anode
2: Organic layer
3: Light-emitting layer
4: Cathode
5: Substrate
6: Electron transport layer
7: Electron injection layer
A: Charge transport polymer A
B: Charge transport polymer B

## Claims

1. A charge transport material comprising a charge transport polymer A having at least one type of group selected from the group consisting of fluoroalkyl groups and fluoroaryl groups, and a charge transport polymer B having no fluoroalkyl groups and no fluoroaryl groups.

2. The charge transport material according to Claim 1, wherein the material is used in forming at least one type of layer selected from the group consisting of hole injection layers, hole transport layers, and electron blocking layers.

3. The charge transport material according to Claim 1 or 2, wherein at least one polymer selected from the group consisting of the charge transport polymer A and the charge transport polymer B has a branched structure.

4. The charge transport material according to any one of Claims 1 to 3, wherein number average molecular weights of the charge transport polymer A and the charge transport polymer B are both 1,000 or greater.

5. The charge transport material according to any one of Claims 1 to 4, wherein the charge transport polymer A and the charge transport polymer B both comprise at least one type of structural unit selected from the group consisting of structural units containing an aromatic amine structure and structural units containing a carbazole structure.

6. An ink composition comprising the charge transport material according to any one of Claims 1 to 5, and a solvent.

7. An organic layer comprising the charge transport material according to any one of Claims 1 to 5, wherein the charge transport polymer A is localized at one surface of the organic layer.

8. An organic electronic element comprising the organic layer according to Claim 7.

9. An organic electroluminescent element comprising the organic layer according to Claim 7.

10. A display element comprising the organic electroluminescent element according to Claim 9.

11. An illumination device comprising the organic electroluminescent element according to Claim 9.

12. A display device comprising the illumination device according to Claim 11, and a liquid crystal element as a display unit.

13. A method for producing an organic layer comprising a step of coating the ink composition according to Claim 6.

14. A method for producing an organic electronic element comprising a step of coating the ink composition according to Claim 6.

15. A method for producing an organic electroluminescent element comprising a step of coating the ink composition according to Claim 6.
